Europäisches Patentamt

European Patent Office

Office européen des brevets

(11) Veröffentlichungsnummer : **0 158 208**
**B1**

(12) **EUROPÄISCHE PATENTSCHRIFT**

(45) Veröffentlichungstag der Patentschrift :
16.06.87

(51) Int. Cl.⁴ : **H 01 F  7/22**

(21) Anmeldenummer : 85103520.4

(22) Anmeldetag : 25.03.85

(54) Schaltungsanordnung zur Überwachung einer supraleitenden Magnetwicklung.

(30) Priorität : 06.04.84 DE 3413127

(43) Veröffentlichungstag der Anmeldung :
16.10.85 Patentblatt 85/42

(45) Bekanntmachung des Hinweises auf die Patenterteilung : 16.06.87 Patentblatt 87/25

(84) Benannte Vertragsstaaten :
DE FR GB NL

(56) Entgegenhaltungen :
DE-A- 2 210 863
DE-A- 2 301 152
DE-A- 2 828 913
DE-A- 2 839 787

(73) Patentinhaber : **Siemens Aktiengesellschaft Berlin und München**
**Wittelsbacherplatz 2**
**D-8000 München 2 (DE)**

(72) Erfinder : **Intichar, Lutz, Dr. Dipl.-Ing.**
**Max-Busch-Strasse 12**
**D-8520 Erlangen (DE)**

## Beschreibung

Die Erfindung bezieht sich auf eine Schaltungsanordnung zur Überwachung des supraleitenden Zustandes einer supraleitenden Magnetwicklung, welche in zwei hintereinandergeschaltete Teilwicklungen mit einer dazwischenliegenden Anzapfungsstelle unterteilt ist und deren Enden über einen elektrisch leitenden Parallelzweig verbunden sind, der aus zwei hintereinandergeschalteten, jeweils mindestens einen Widerstand vorbestimmter ohmscher Größe enthaltenden Teilzweigen mit einer dazwischenliegenden Anschlußstelle besteht, wobei diese Anschlußstelle des Parallelzweiges und die Anzapfungsstelle der Magnetwicklung die Diagonalpunkte einer Brückenschaltung sind, an denen eine elektronische Einrichtung zur Auswertung und Weiterverarbeitung des zwischen diesen Punkten zu messenden Spannungssignals angeschlossen ist. Eine derartige Schaltungsanordnung ist aus der DE-OS 28 39 787 bekannt.

Supraleitende Magnetwicklungen, insbesondere mit größerem Energieinhalt, sind bei einem unbeabsichtigten Übergang vom supraleitenden Betriebszustand in den normalleitenden Zustand stark gefährdet, selbst wenn dieser auch als « Quench » bezeichnete Übergang zunächst nur in einem Teil der Wicklung auftritt. Infolge der geringen Wärmekapazität der supraleitenden Wicklungsleiter nimmt nämlich der Leiter nach einem Übergang vom supraleitenden in den normalleitenden Zustand durch die dadurch bedingte Widerstandserhöhung sehr schnell eine hohe Temperatur an. Gleichzeitig steigt auch sein spezifischer Widerstand sehr rasch an, wodurch die Erwärmung noch beschleunigt wird. Außerdem treten dabei elektrische Spannungen auf, welche die Isolation der Wicklung beanspruchen.

Um größere supraleitende Magnetwicklungen vor einer Beschädigung oder Zerstörung durch Überhitzung bzw. durch elektrische Überschläge zu schützen, sind besondere Schutzmaßnahmen erforderlich. Diese Maßnahmen bestehen z. B. darin, daß man die Magnetwicklung in mehrere Teilwicklungen unterteilt, die zur Spannungsbegrenzung jeweils mit ohmschen Schutzwiderständen (vgl. DE-OS 23 01 152), Halbleiterdioden (vgl. DE-OS 16 14 964) oder Überspannungsableitern (vgl. DE-OS 17 64 369) überbrückt sind.

Neben diesen passiven Schutzmaßnahmen sind im allgemeinen noch aktive Elemente, insbesondere sogenannte Quenchdetektoren, erforderlich, um die supraleitende Magnetwicklung bei einem Normalleitendwerden (Quench) wie insbesondere während der Auferregungsphase möglichst rasch von einer externen Energieversorgung abtrennen zu können. Mit solchen Detektoreinrichtungen wird im allgemeinen die an der supraleitenden Magnetwicklung sich einstellende elektrische Spannung überwacht, die neben dem zu detektierenden ohmschen Spannungsabfall über der Wicklung noch das induktive Signal L · di/dt sowie ein um Größenordnungen kleineres Spannungssignal aus den Ummagnetisierungsverlusten der Supraleiter selbst enthält. Im einfachsten Fall wird nur die Gesamtspannung mit einem vorgegebenen Höchstwert verglichen. Das kleinste entdeckbare ohmsche Signal liegt dabei in der Größenordnung des induktiven Signals.

Bei demgegenüber verbesserten Überwachungsschaltungen wird das induktive Signal kompensiert ; das kleinste entdeckbare ohmsche Signal liegt dann nämlich in der Größenordnung des durch die Leiterverluste bestimmten Signals. Noch bessere Schaltungen kompensieren auch dieses.

Die Schaltungsanordnung eines entsprechenden Quenchdetektors ist in der eingangs genannten DE-OS 28 39 787 näher beschrieben. Dabei wird von einer supraleitenden Magnetwicklung ausgegangen, die durch eine Mittelanzapfung in zwei Teilwicklungen unterteilt ist. Bei derartigen Wicklungen, die aus zwei symmetrisch aufgebauten Hälften bestehen, kann nämlich durch analogen Vergleich der Spannungen über den beiden Wicklungshälften eine Überwachung realisiert werden, indem die beiden Teilwicklungen zusammen mit mindestens zwei externen Widerständen als Brücke geschaltet sind. Bei einer solchen Schaltungsanordnung können jedoch die insbesondere von Lötstellen herrührenden ohmschen Widerstände der supraleitenden Magnetwicklung nicht mitkompensiert werden, so daß der Auflösung bzw. Empfindlichkeit der Schaltungsanordnung hierdurch entsprechende Grenzen gesetzt sind. Um diese ohmschen Widerstände möglichst klein zu halten, ist man auch bestrebt, die externen Widerstände der Brücke unmittelbar an die Enden der Wicklung anzuschließen. Aus räumlichen Gründen ist dies jedoch nicht immer möglich.

Aufgabe der vorliegenden Erfindung ist es deshalb, die Empfindlichkeit der eingangs genannten Schaltungsanordnung hinsichtlich der Erfassung von Änderungen an Widerständen und/oder Induktivitäten zu steigern, wobei mit ihr insbesondere auch die den Teilwicklungen der supraleitenden Magnetwicklung zuzuordnenden ohmschen Widerstände mit berücksichtigt werden sollen.

Diese Aufgabe wird erfindungsgemäß dadurch gelöst, daß jeder Teilzweig des Parallelzweiges mindestens einen Kondensator vorbestimmter Kapazität enthält. Die Kondensatoren können dabei zu den jeweils zugeordneten Widerständen parallel- oder hintereinandergeschaltet sein. Die konkreten Werte der Widerstände und Kondensatoren werden in Anpassung an die ohmschen und induktiven Widerstände der jeweiligen Magnetwicklung so ausgelegt, daß zwischen den Diagonalpunkten der Brückenschaltung im ungestörten Betriebsfall Spannungslosigkeit herrscht.

Die mit der erfindungsgemäßen Ausgestaltung der Schaltungsanordnung verbundenen Vorteile sind darin zu sehen, daß sich durch die Integration von Kondensatoren in die Brückenschaltung auch die ohmschen Widerstände der Wicklung mit kompensieren lassen. Damit ist zum einen ein unmittelbarer Anschluß der externen Widerstände bzw. Kondensatoren der Brücke an die Enden der Wicklung nicht mehr erforderlich. Zum anderen ist die Schaltungsanordnung wesentlich empfindlicher einzustellen als die bekannte Schaltungsanordnung.

Besonders vorteilhaft ist es, wenn der ohmsche Widerstand jedes Teilzweiges mit einem Abgriff versehen ist und wenn diese Widerstandsabgriffe in den beiden Teilzweigen über ein aus mindestens einem Widerstand und mindestens einem Kondensator bestehendes Schaltungsglied miteinander verbunden sind. Dann läßt sich nämlich das Auftreten einer widerstandsbehafteten normalleitenden Zone in der Magnetwicklung selbst dann empfindlich feststellen, wenn die Magnetwicklung mit mindestens einem Kurzschlußkreis magnetisch gekoppelt ist, wobei eine solche Kopplung im allgemeinen zu einer Asymmetrie zwischen den beiden Wicklungshälften bzw. Teilwicklungen führt. Bei den Kurzschlußkreisen kann es sich um elektrisch leitfähige Materialien handeln, in denen Wirbelströme induziert werden, oder um diskrete Leiterschleifen mit inneren und/oder äußeren festen Widerständen.

Weitere vorteilhafte Ausgestaltungen der Schaltungsanordnung nach der Erfindung gehen abhängigen aus den übrigen Ansprüchen hervor.

Zur weiteren Erläuterung der Erfindung wird nachfolgend auf die Zeichnung Bezug genommen, aus deren Figur 1 eine Schaltungsanordnung nach der Erfindung hervorgeht. Figur 2 zeigt einen Teil des Netzwerkes einer weiteren Ausführungsform einer erfindungsgemäßen Schaltungsanordnung. In Figur 3 ist eine Ersatzschaltung für eine supraleitende Magnetwicklung mit gekoppelten Kurzschlußkreisen wiedergegeben, deren zugehörende Schaltungsanordnung in Figur 4 dargestellt ist. Dabei sind in den Figuren übereinstimmende Teile mit denselben Bezugszeichen versehen.

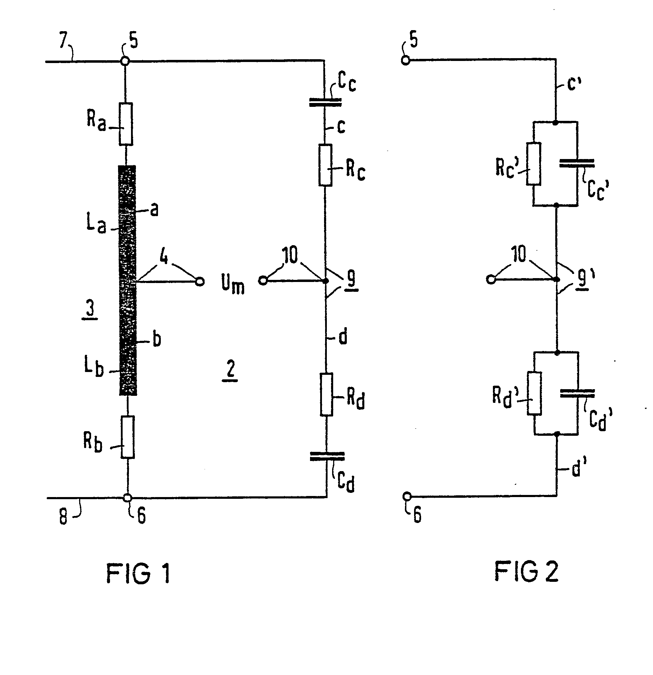

Bei dem in Figur 1 gezeigten Prinzipschaltbild einer Schaltungsanordnung nach der Erfindung wird von einer bekannten Schaltungsanordnung ausgegangen, wie sie z. B. in der eingangs genannten DE-OS 28 39 787 (vgl. deren Figur 1) beschrieben ist. Die allgemein mit 2 bezeichnete Anordnung stellt eine Brückenschaltung dar, deren einer Zweig aus einer zu überwachenden supraleitenden Magnetwicklung 3 gebildet wird. Diese Wicklung weist eine mittlere Anzapfungsstelle 4 auf, durch welche die Wicklung in zwei gleichgroße, annähernd symmetrische Hälften bzw. Teilwicklungen a und b mit Induktivitäten $L_a$ bzw. $L_b$ unterteilt ist. Die den Teilwicklungen a und b im supraleitenden Betriebszustand zuzuordnenden ohmschen Widerstände sind dabei mit $R_a$ bzw. $R_b$ bezeichnet. An den Enden 5 bzw.

6 dieser Teilwicklungen ist die Magnetwicklung 3 zum einen über Anschlußleitungen 7 und 8 mit einer externen, nicht dargestellten Stromversorgung abschaltbar verbunden. Zum anderen ist an diesen Enden 5 und 6 der zweite Zweig der Brückenschaltung parallel zur Magnetwicklung angeschlossen. Dieser allgemein mit 9 bezeichnete Parallelzweig ist durch eine mittlere Anschlußstelle 10 in zwei Teilzweige c bzw. d unterteilt. Jeder dieser Teilzweige besteht aus einer Reihenschaltung von einem Widerstand $R_c$ bzw. $R_d$ und einem Kondensator $C_c$ bzw. $C_d$. An die Anzapfungsstelle 4 der Magnetwicklung 3 und die Anschlußstelle 10 in dem Parallelzweig 9 ist eine in der Figur nicht dargestellte Einrichtung zur Auswertung und Weiterverarbeitung des zwischen diesen Punkten zu messenden Spannungssignals $U_m$ angeschlossen, um in einem Störungsfall wie z. B. einem Quench die externe Stromversorgung möglichst rasch abschalten zu können und gegebenenfalls noch weitere aktive Schutzmaßnahmen einzuleiten. Entsprechende Auswert- und Weiterverarbeitungseinrichtungen sind allgemein bekannt (vgl. z. B. die genannte DE-OS 28 39 787, insbesondere deren Figur 1).

Im Ausgangszustand der Schaltung 2, d. h. im supraleitenden Betriebszustand der Magnetwicklung 3, werden die Widerstände und Kondensatoren so abgeglichen, daß die Spannung $U_m$ zwischen der Anzapfungsstelle 4 und der Anschlußstelle 10 praktisch null ist. Diese Bedingung ist für jeden Strom mit beliebiger zeitlicher Form erfüllt, wenn die folgenden Beziehungen eingehalten sind :

$$\tau \cdot R_c = L_a \; ; \; \tau = R_a \cdot C_c \; ;$$

$$\tau \cdot R_d = L_b \text{ und } \tau = R_b \cdot C_d.$$

Darin ist $\tau$ eine freie wählbare Maßstabs-Zeitkonstante. Sie gibt die Möglichkeit, die Resonanzfrequenzen $(2\pi \sqrt{L \cdot C})^{-1}$ für die verschiedenen Kombinationen von L und C außerhalb etwaiger Anregefrequenzen zu legen. Die Dämpfung in dem Kreis ist proportional $\tau^{-1}$, was für möglichst kleine Werte von $\tau$ spricht. Andererseits muß der Eingangswiderstand der $U_m$ erfassenden Auswerteinrichtung hoch im Vergleich zu $R_c$ und $R_d$ gewählt werden.

Wie aus den vorstehenden Bedingungen ohne weiteres ablesbar ist, wird durch die Einfügung der Kondensatoren $C_c$ und $C_d$ in den Parallelzweig 9 vorteilhaft eine Berücksichtigung der ohmschen Widerstände $R_a$ und $R_b$ der Magnetwicklung 3 und damit eine entsprechende Empfindlichkeit der Schaltungsanordnung bei Verstimmung der Brücke aufgrund eines Quenches ermöglicht.

Statt der gemäß Figur 1 angenommenen Reihenschaltung von R-C-Gliedern in dem Parallelzweig zu der zu überwachenden supraleitenden Magnetwicklung ist auch eine Parallelschaltung von Kondensatoren und Widerständen möglich. Dementsprechend wird gemäß dem Prinzipschaltbild nach Figur 2 ein Parallelzweig 9' des an die Magnetwicklung an deren Enden 5 und 6 angeschlossenen Netzwerkes aus zwei Teilzweigen c' und d' gebildet, die jeweils aus einem Widerstand $R'_c$ bzw. $R'_d$ mit parallelgeschaltetem Kondensator $C'_c$ bzw. $C'_d$ bestehen. Bei Verwendung dieses Netzwerkes in einer Brückenschaltung gemäß Figur 1 ist dann das Spannungssignal $U_m$ zwi-schen den Diagonalpunkten 4 und 10 der Brückenschaltung null, wenn die folgenden Be-dingungen erfüllt sind :

$$r^2 C'_d = L_a \; ; \; r^2 = R_a \cdot R'_d$$

$$r^2 C'_c = L_b \; ; \; r^2 = R_b \cdot R'_c.$$

Dabei ist r ein frei wählbarer Maßstabswiderstand, der nach ähnlichen Gesichtspunkten wie die Zeitkonstante gemäß Figur 1 festgelegt wird.

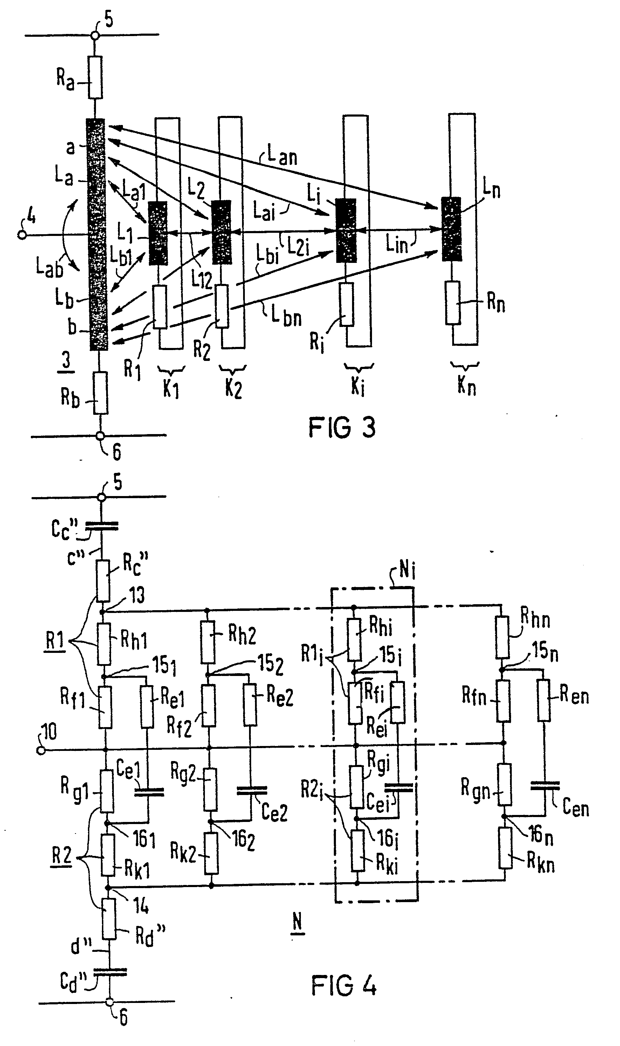

Bei den in den Figuren 1 und 2 gezeigten Netzwerken der zu der zu überwachenden supraleitenden Magnetwicklung parallelgeschalteten Brückenzweige wurde davon ausgegangen, daß nur die Induktivitäten der Wicklung selbst für eine Kompensation innerhalb der Brückenschaltung zu berücksichtigen sind. Vielfach sind jedoch in der Magnetwicklung zusätzliche Kurzschlußkreise aus elektrisch leitenden Teilen ausgebildet, wel-che vorbestimmte Eigeninduktivitäten und -wi-derstände aufweisen. Ein entsprechendes Ersatz-schaltbild geht aus Figur 3 hervor. Danach ist die supraleitende Magnetwicklung 3 gemäß Figur 1 mit den Induktivitäten $L_a$ und $L_b$ ihrer zunächst symmetrischen Teilwicklungen a und b sowie mit den Teilwicklungswiderständen $R_a$ und $R_b$ magnetisch mit n Kurzschlußkreisen $K_1$ bis $K_n$ gekoppelt. Die Zahl n hängt dabei von der ange-strebten Empfindlichkeit der Schaltungsanord-nung zur Überwachung der jeweiligen Magnetwicklung ab. In die zu wählende Größe der Empfindlichkeit geht dabei der Aufbau der Magnetwicklung ein, nämlich z. B. ob in Stahlplat-ten oder Aluminiumringen angefachte Wirbelströ-me mit berücksichtigt werden müssen. Die erwähnten Kurzschlußkreise, die jeweils eine Induktivität $L_1$ bis $L_n$ und einen ohmschen Wider-stand $R_1$ bis $R_n$ aufweisen, führen demnach mit den Teilwicklungen und auch untereinander zu Kopplungsinduktivitäten, die in der Figur nur teilweise durch gepfeilte Linien $L_{a1}$ bis $L_{an}$, $L_{b1}$ bis $L_{bn}$ bzw. $L_{12}$ bis $L_{in}$ (mit $1 \leq i \leq n - 1$) ange-deutet sind. Diese Kopplungsinduktivitäten führen im allgemeinen zu einer Asymmetrie der beiden Wicklungshälften, so daß bei Erregungs-änderungen in der Schaltungsanordnung gemäß den Figuren 1 und 2 Spannungssignale erzeugt werden, die die Auflösung für einen Widerstand in der Wicklung selbst herabsetzen.

Um diesen Einfluß der Kurzschlußkreise zu kompensieren, wird vorteilhaft der Parallelzweig der Brückenschaltung gemäß Figur 1 zu einem Netzwerk ausgebildet, das aus Figur 4 näher hervorgeht.

Dieses mit N bezeichnete Netzwerk unterscheidet sich von dem Netzwerk des Parallelzweiges 9 gemäß Figur 1 dadurch, daß, abgesehen von den unterschiedlichen Größen der Kondensatoren $C''_c$ und $C''_d$ sowie der Widerstände $R''_c$ und $R''_d$ in den Teilzweigen c'' bzw. d'', diese Widerstände nicht unmittelbar mit der Anschlußstelle 10 verbunden sind, sondern daß zwischen ihren entsprechenden freien Enden 13 bzw. 14 eine vorbestimmte Anzahl n von untereinander parallelge-schalteten Teilnetzwerken $N_1$ bis $N_n$ liegen. Diese Anzahl n entspricht dabei der Anzahl der berück-sichtigten Kurzschlußkreise $K_n$ gemäß Figur 3.

Nachfolgend sei das i-te Teilnetzwerk $N_i$ betrachtet, das in der Figur durch eine strichpunktierte Linie umrissen ist. Der Index i läuft dabei für das Gesamtnetzwerk N von 1 bis n. Das Teilnetzwerk enthält zwischen dem freien Ende 13 des Widerstandes $R''_c$ und der Anschlußstelle 10 zwei hintereinandergeschaltete Widerstände $R_{hi}$ und $R_{fi}$. In entsprechender Weise sind zwischen das Ende 14 und die Anschlußstelle 10 zwei Wider-stände $R_{ki}$ und $R_{gi}$ geschaltet. Dabei ist zwischen den Widerstandspaaren $R_{hi}$-$R_{fi}$ und $R_{ki}$-$R_{gi}$ je eine Verbindungsstelle 15i bzw. 16i ausgebildet. Diese Verbindungsstellen sind ferner über ein R-C-Glied mit einer Hintereinanderschaltung eines Widerstandes $R_{ei}$ und eines Kondensators $C_{ei}$ miteinander verbunden.

Betrachtet man z. B. das Teilnetzwerk $N_1$ in dem Gesamtnetzwerk N, so können z. B. die hintereinandergeschalteten Widerstände $R_c''$-$R_{h1}$-$R_{f1}$ als ein gemeinsamer Widerstand R1 angesehen werden, der mit zwei Abgriffen versehen ist, die durch das freie Ende 13 des Widerstandes $R''_c$ bzw. durch die Verbindungsstelle $15_1$ gebildet sind. Entsprechendes gilt auch für die Wider-standskette $R_d''$$R_{k1}$-$R_{g1}$ mit Abgriffen 14 und $16_1$. Ferner können auch für das Teilnetzwerk $N_i$ allein die hintereinandergeschalteten Widerstände $R_{hi}$ und $R_{fi}$ sowie die Widerstände $R_{ki}$ und $R_{gi}$ jeweils durch einen Widerstand R1$_i$ bzw. R2$_i$ mit Abgriffen 15$_i$ bzw. 16$_i$ ersetzt sein.

Das an die supraleitende Magnetwicklung angeschlossene Netzwerk N setzt sich somit aus einer Reihe von Kondensatoren und Widerständen zusammen, die so angeordnet und abgestimmt sind, daß für einen vorgegebenen Zustand an Induktivitäten und Widerständen in der Magnetwicklung und allen gekoppelten Kurzschlußkreisen das Meßsignal zumindest nahezu null ist, unabhängig vom Strom in der Magnetwicklung oder von der Geschwindigkeit, mit der die Magnetwicklung auferregt wird. Erst eine Veränderung des Leitfähigkeitszustandes der Magnetwicklung, beispielsweise durch eine normalleitende Zone in der Wicklung, führt dann zu einem Meßsignal. Die konkreten Werte der Widerstände und Kondensatoren dieses Netzwerkes sind in Abhängigkeit von der jeweiligen Ausgestaltung der supraleitenden Magnetwicklung zu wählen.

Hierzu bestimmt man experimentell zunächst die konkreten Werte der in Fig. 3 angedeuteten Induktivitäten und Widerstände nach bekannten Verfahren. So kann man z. B. einen vorbestimmten Einheitsspannungsstoß an die Enden 5 und 6 sowie an jeweils einem dieser Enden und der Mittelanzapfung 4 der Wicklung anlegen und die sich ergebende Kurvenform des Stromverlaufes in einem Diagramm aufnehmen. Die Analyse dieses Kurvenverlaufes liefert dann die Anzahl der vorzusehenden Zweige des Netzwerkes sowie die Widerstände und Induktivitäten des entsprechenden Ersatzschaltbildes.

Neben der beschriebenen experimentellen Ermittlung der charakteristischen Werte der Magnetwicklung aus dem Verlauf der Stromkurven, die sich bei Anlagen von Einheitsspannungsstößen an den Punkten 4 bis 6 ergeben, sind ebenso auch andere bekannte Verfahren möglich. So lassen sich die genannten Werte auch aus den Frequenzgängen von Strom-Orts-Kurven gewinnen, die sich bei Anlegen von z. B. sinusförmigen Wechselspannungen mit verschiedenen Frequenzen an die Punkte 4 bis 6 ergeben. Ein entsprechendes Verfahren ist auch z. B. in dem Bericht der « International Conference on Electric Machines (ICEM), Lausanne (Schweiz), 1984, mit dem Titel : « Considerations about the electrical supervision of the superconducting field winding of a 320 kVA synchronous generator » (Autoren : H. Bischof, W. Engl, H. W. Lorenzen, T. Tietze) zugrundegelegt. Das Netzwerk für die beiden noch freien Teilzweige der Brückenschaltung wird dementsprechend so ausgelegt, daß es gleich viele parallele Zweige wie das Ersatzschaltbild der Magnetwicklung aufweist. Mit der Brückenbedingung, wonach im ungestörten Betriebsfall Spannungslosigkeit zwischen den Punkten 4 und 10 herrschen soll, ergibt sich dann nach den allgemein bekannten Regeln zur Berechnung elektrischer Netzwerke ein Gleichungssystem entsprechender Ordnung. Aus diesem Gleichungssystem lassen sich dann die einzelnen Werte für die Kondensatoren und Widerstände des Netzwerkes errechnen. Hierzu wird von dem sich für die einzelnen Spannungen und Ströme durch das Netzwerk ergebenden Gleichungssysten ausgegangen, das im Falle höherer Ordnungen zweckmäßigerweise in Laplacetransformierter Form angesetzt wird.

Bei dem in Figur 4 veranschaulichten Netzwerk N wurde davon ausgegangen, daß die Kondensatoren jeweils in Reihe zu einem Widerstand entsprechend Figur 1 geschaltet sind. Gegebenenfalls kann jedoch statt einer solchen Reihenschaltung auch eine Parallelschaltung von Widerständen und Kondensatoren gemäß Figur 2 vorgesehen werden. Außerdem kann das dargestellte Netzwerk nach den bekannten Techniken elektrischer Netzwerke zu einem in seiner Funktion analogen Netzwerk abgeändert, beispielsweise hinsichtlich einer Minimalisierung von Einzelteilen optimiert werden.

**Patentansprüche**

1. Schaltungsanordnung zur Überwachung des supraleitenden Zustandes einer supraleitenden Magnetwicklung, welche in zwei hintereinandergeschaltete Teilwicklungen (1a, 1b) mit einer dazwischenliegenden Anzapfungsstelle (4) unterteilt ist und deren Enden über einen elektrisch leitenden Parallelzweig verbunden sind, der aus zwei hintereinandergeschalteten, jeweils mindestens einen Widerstand vorbestimmter ohmscher Größe enthaltenden Teilzweigen mit einer dazwischenliegenden Anschlußstelle (10) besteht, wobei diese Anschlußstelle des Parallelzweiges (10) und die Anzapfungsstelle der Magnetwicklung (4) die Diagonalpunkte einer Brückenschaltung sind, an denen eine elektronische Einrichtung zur Auswertung und Weiterverarbeitung des zwischen diesen Punkten zu messenden Spannungssignals angeschlossen ist, dadurch gekennzeichnet, daß jeder Teilzweig (c bis c", d bis d") des Parallelzweiges (9, 9') mindestens einen Kondensator ($C_c$ bis $C''_c$, $C_d$ bis $C''_d$) vorbestimmter Kapazität enthält.

2. Schaltungsanordnung zur Überwachung des supraleitenden Zustandes einer supraleitenden Magnetwicklung, welche mit einem Kurzschlußkreis magnetisch gekoppelt ist, nach Anspruch 1, dadurch gekennzeichnet, daß der ohmsche Widerstand (R1, R2) jedes Teilzweiges (c", d") mit einem Abgriff ($15_1$ bzw. $16_1$) versehen ist und daß diese Widerstandsabgriffe ($15_1$, $16_1$) in den beiden Teilzweigen (c", d") über ein aus mindestens einem Widerstand ($R_{e1}$) und mindestens einem Kondensator ($C_{e1}$) bestehendes Schaltungsglied miteinander verbunden sind.

3. Schaltungsanordnung zur Überwachung des supraleitenden Zustandes einer supraleitenden Magnetwicklung, welche zusätzlich mit einer vorbestimmten Anzahl i (mit $2 \leqslant i \leqslant n$) Kurzschlußkreisen magnetisch gekoppelt ist, nach Anspruch 2, dadurch gekennzeichnet, daß jeder der mit einem ersten Abgriff ($15_1$ bzw. $16_1$) versehenen Widerstände (R1, R2) der Teilzweige (c", d") einen zweiten Abgriff (13 bzw. 14) enthält, daß zwischen diese zweiten Abgriffe (13, 14) mindestens ein Teilnetzwerk ($N_i$) geschaltet ist, das jeweils einen mit der Anschlußstelle (10) verbundenen Widerstand ($R1_i$, $R2_i$) enthält, der mit einem Abgriff ($15_i$ bzw. $16_i$) versehen ist, und daß diese Abgriffe ($15_i$, $16_i$) des Teilnetzwerkes ($N_i$) über ein weiteres Schaltungsglied aus mindestens einem Widerstand ($R_{ei}$) und einem Kondensator ($C_{ei}$) miteinander verbunden sind.

4. Schaltungsanordnung nach Anspruch 2 oder 3, dadurch gekennzeichnet, daß die mit Abgriffen ($15_i$, $16_i$, 13, 14) versehenen Widerstände (R1, R2, $R1_i$, $R2_i$) durch einzelne Festwiderstände ersetzt sind.

5. Schaltungsanordnung nach einem der Ansprüche 1 bis 4, gekennzeichnet durch eine Reihen- oder Parallelschaltung der Kondensatoren zu den ihnen zugeordneten Widerständen.

6. Schaltungsanordnung nach einem der Ansprüche 1 bis 5, dadurch gekennzeichnet, daß zumindest einige der unmittelbar hintereinandergeschalteten Widerstände jeweils zu entsprechenden Gesamtwiderständen zusammengefaßt sind.

Claims

1. A surveillance circuit arrangement for the superconductive state of a superconductive magnet winding divided into two consecutively switched sub-windings (1a, 1b) having an intermediate tapping (4), and whose ends are connected by an electrically conductive parallel branch which consists of two consecutively switched sub-branches having an intermediate connection point (10) and respectively comprise at least one resistor of a predetermined magnitude, where said connection point of the parallel branch (10) and the tapping of the magnet winding (4) are the diagonal points of a bridge circuit, to which an electronic device for analysing and processing the voltage signal to be measured between said points is connected, characterised in that each sub-branch (c to c″, d to d″) of the parallel branch (9, 9′) comprises at least one capacitor ($C_c$ to $C''_c$, $C_d$ to $C''_d$) of predetermined capacitance.

2. A surveillance circuit arrangement for the superconductive state of a superconductive magnet winding as claimed in Claim 1, magnetically coupled to a short circuit, characterised in that the resistance (R1, R2) of each sub-branch (c″, d″) is provided with a tap ($15_1$ and $16_1$) and that said resistor taps ($15_1$, $16_1$) in the two subbranches are connected together by a switching element which consists of at least one resitor ($R_{e1}$) and at least one capacitor ($C_{e1}$).

3. A surveillance circuit arrangement for the superconductive state of a superconductive magnet winding as claimed in Claim 2, additionally magnetically coupled to a predetermined number i of short circuits, (where i is given by $2 \leqslant i \leqslant n$), characterised in that each of the resistors (R1, R2) of the sub-branches (c″, d″), provided with a first tap ($15_1$ or $16_1$ as the case may be) comprises a second tap (13 or 14 as the case may be), that at least one sub-network ($N_i$) is inserted between said second taps (13, 14), which network respectively comprises a resistor ($R1_i$, $R2_i$) connected to the connection point (10), and is provided with a tap ($15_i$ or $16_i$ as the case may be), and that said taps ($15_i$, $16_i$) of the sub-network ($N_i$) are connected together by a further circuit element consisting of at least one resistor ($R_{ei}$) and one capacitor ($C_{ei}$).

4. A circuit arrangement as claimed in Claim 2 or 3, characterised in that individual fixed resistors are used in place of the resistors (R1, R2, $R1_i$, $R2_i$) provided with taps ($15_i$, $16_i$, 13, 14).

5. A circuit arrangement as claimed in one of Claims 1 to 4, characterised by a series or parallel connection of the capacitors in relation to the respective resistors assigned thereto.

6. A circuit arrangement as claimed in one of Claims 1 to 5, characterised in that at least some of the respective directly consecutively arranged resistors are combined in the form of common resistors of equivalent total value.

Revendications

1. Montage pour contrôler l'état supraconducteur d'un enroulement magnétique supraconducteur, qui est subdivisé en deux enroulements partiels (1a, 1b) branchés en série avec un point intercalé formant prise (4) et dont les extrémités sont reliées par l'intermédiaire d'une branche parallèle électriquement conductrice, qui est constituée par deux branches partielles montées en série et possédant chacune au moins une résistance possédant une valeur ohmique prédéterminée, avec un point intercalé de raccordement (10), ce point de raccordement de la branche parallèle (10) et le point formant prise de l'enroulement magnétique (7) étant les points opposés en diagonale d'un circuit en pont, auxquels est raccordé un dispositif électronique servant à évaluer et à réaliser le traitement ultérieur du signal de tension devant être mesuré entre ces points, caractérisé par le fait que chaque branche partielle (c à c″, d à d″) de la branche parallèle (9, 9′) contient au moins un condensateur ($C_c$ à $C''_c$, $C_d$ à $C''_d$) possédant une capacité prédéterminée.

2. Montage pour contrôler l'état supraconducteur d'un enroulement magnétique supraconducteur, qui est accouplé magnétiquement à un circuit de court-circuit, suivant la revendication 1, caractérisé par le fait que la résistance ohmique (R1, R2) de chaque branche partielle (c″, d″) est munie d'une prise ($15_1$ ou $16_1$) et que ces prises ($15_1$, $16_1$) de la résistance dans les deux branches partielles (c″, d″) sont reliées entre elles par l'intermédiaire d'un élément de circuit constitué par au moins une résistance ($R_{e1}$) et par au moins un condensateur ($C_{e1}$).

3. Montage pour contrôler l'état supraconducteur d'un enroulement magnétique supraconducteur, qui est en outre accouplé magnétiquement à un nombre prédéterminé i (avec $2 \leqslant i \leqslant n$), de montages de court-circuit, selon la revendication 2, caractérisé par le fait que chacune des résistances (R1, R2), munies d'une première prise ($15_1$ ou $16_1$) des branches partielles (c″, d″) contient une seconde prise (13 ou 14), qu'entre ces deux prises (13, 14) se trouve branché au moins un réseau partiel ($N_i$) qui contient respectivement une résistance ($R1_i$, $R2_i$) reliée au point de raccordement (10) et qui est munie d'une prise ($15_i$ ou $16_i$), et que ces prises ($15_i$, $16_i$) du réseau partiel ($N_i$) sont reliées par l'intermédiaire d'un autre élément de circuit formé par au moins une résistance ($R_{ei}$) et un condensateur ($C_{ei}$).

4. Montage selon la revendication 2 ou 3, caractérisé par le fait que les résistances (R1, R2, $R1_i$, $R2_i$) munies des prises ($15_i$, $16_i$, 13, 14) sont remplacées par des résistances fixes individuelles.

5. Montage suivant l'une des revendications 1 à 4, caractérisé par un montage série ou parallèle des condensateurs avec les résistances qui leur sont associées.

6. Montage suivant l'une des revendications 1 à 5, caractérisé par le fait qu'au moins quelques-unes des résistances branchées directement en série sont réunies respectivement pour former des résistances globales correspondantes.

FIG 1

FIG 2

**FIG 3**

**FIG 4**